(19) Europäisches Patentamt

European Patent Office

Office européen des brevets

(11) EP 0 562 737 B1

## (12) EUROPEAN PATENT SPECIFICATION

(45) Date of publication and mention
of the grant of the patent:
**17.06.1998  Bulletin 1998/25**

(51) Int Cl.⁶: **G11C 16/06**

(21) Application number: **93301796.4**

(22) Date of filing: **10.03.1993**

(54) **Flash memory**

Flash-Speicher

Mémoire flash

(84) Designated Contracting States:
**DE FR GB IT**

(30) Priority: **26.03.1992  JP  68099/92**
**08.01.1993  JP  18095/93**

(43) Date of publication of application:
**29.09.1993  Bulletin 1993/39**

(73) Proprietors:
• **Hitachi, Ltd.**
  **Chiyoda-ku, Tokyo 101-0062 (JP)**
• **HITACHI VLSI ENGINEERING CORPORATION**
  **Kodaira-shi, Tokyo (JP)**

(72) Inventors:
• **Siba, Kazuyosi**
  **Kodaira-shi, Tokyo (JP)**
• **Terasawa, Masaaki**
  **Akishima-shi, Tokyo (JP)**

(74) Representative: **Calderbank, Thomas Roger et al**
**MEWBURN ELLIS**
**York House**
**23 Kingsway**
**London WC2B 6HP (GB)**

(56) References cited:
**EP-A- 0 376 063          EP-A- 0 450 632**
**US-A- 4 949 309**

## Description

The present invention relates to a single flash memory, particularly, to a semiconductor integrated circuit such as a microcomputer having the flash memory built therein and, more particularly, to a technology which is effective for stabilizing the erasure characteristics.

An EEPROM in accordance with the precharacterising portion of claim 1 is known from US-A-4 949 309, EP-A-0 450 632 discloses an EEPROM which allows concurrent selection of either the odd or the even numbered word lines to facilitate writing of a checker board pattern in to the cell array for test purposes.

The flash memory is enabled to rewrite the data by electric erasing/writing operations and can have its memory cell constructed of one transistor like the EPROM. The flash memory has a function to batch-erase all the memory cells or the block of the memory cells electrically. As a result, the flash memory can rewrite its stored data while being in the state (i.e., on-board), in which it is packaged in the system, and is enabled not only to shorten the rewrite time period by its batch erase function but also to contribute to the reduction in the chip occupied area. This flash memory is described on pp. 616 to 619 of Papers published in International Electron Device Meeting in 1985. The flash memory is also described as a bath erase type EEPROM in U.S. Serial No. 07/474,994 (filed on February 5, 1990).

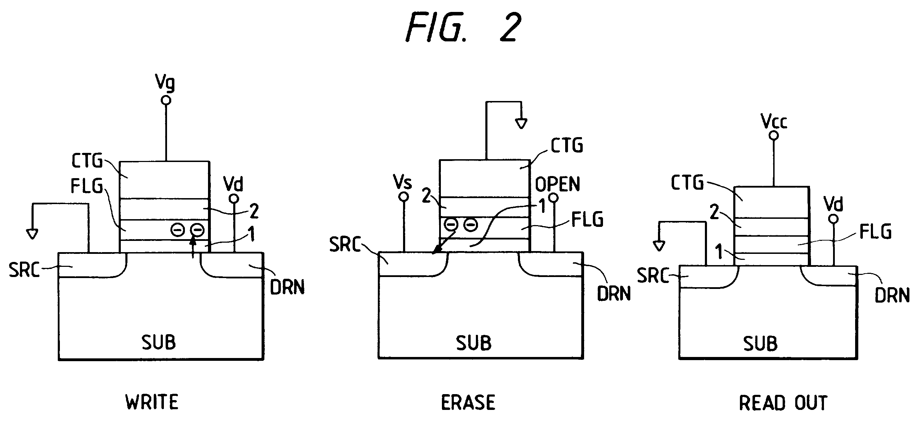

A sectional structure of the device of a flash memory cell is schematically shown in Fig. 2. This memory cell is made of an insulated gate type field effect transistor of two-layer gate structure constructed over a P-type silicon substrate, although not especially limited thereto, and is equipped with a first gate insulating film 1 made of $SiO_2$, a floating gate FLG, a second gate insulating film 2 made of $SiO_2$, a control gate CTG, a source SRC and a drain DRN. The write of the memory cell is carried out like the EPROM by generating hot electrons in the vicinity of the drain DRN and impregnating the floating gate FLG with them. The control gate CTG is supplied with a voltage Vg (e.g., 10 to 14 V); the drain DRN is supplied with a voltage Vd (e.g., 4 to 8 V); and the source SRC and the substrate SUB are grounded to the earth. The erasures are carried out like the EEPROM by extracting the electrons from the floating gate FLG to the source SRC by the FN (i.e., Fowler Nordheim) tunnel current. The source SRC is supplied with a voltage Vs (e.g., 10 to 14 V); the drain DRN is opened; and the control gate CTG and the substrate SUB are grounded to the earth. The reading operations of the memory cell are carried out by applying a voltage Vcc (e.g., 5 V) to the control gate CTG and a voltage such as 1 V dropped from the Vcc to the drain DRN. The channel current will not flow, in case the negative charges are stored in the floating gate FLG, but will flow in case the charges are not stored. For example, the former corresponds to the data "0" whereas the latter corresponds to the data "1".

As a result of the writing operation, the memory cell has its threshold voltage raised to a higher level with respect to its control gate CTG than that of the memory cell in the erased state wherein the writing operation is not performed. In both the writing and erasing states, the threshold value of the storing transistor is set to a positive voltage level. Specifically, the threshold voltage in the write state is made higher whereas the threshold voltage in the erase state is made lower than the word line select level fed from the word lines to the control gate CTG. Thanks to such relation between the two threshold voltages and the word line select level, the memory cell can be constructed of the single transistor without adopting the select transistor. In case the stored data are to be electrically eased, they are erased by extracting the electrons stored in the floating gate FLG to the source electrode SRC. As a result, if the erasing operations are continued for a relatively long time, more electrons than those injected into the floating gate FLG at the time of the writing operation are extracted. Thus, with an excessive erasure in which the electric erasing operation is continued for a relatively long time, the threshold voltage of the memory cell takes a negative level, for example, to raise a disadvantage that the word lines are selected even at an unselect level.

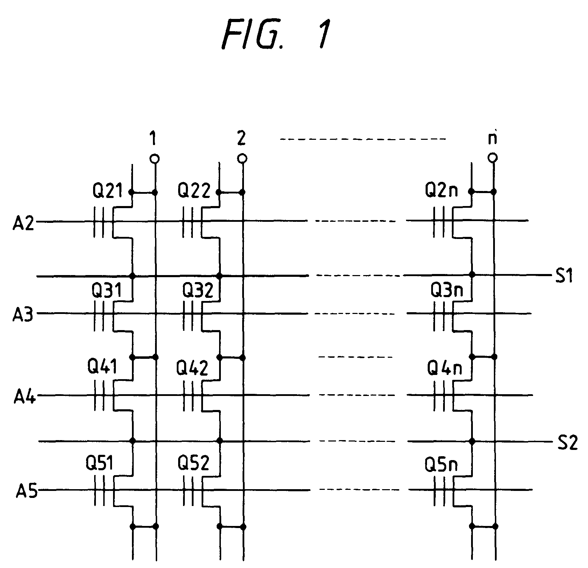

Fig. 1 is a schematic diagram showing an essential portion of a flash memory cell array. Reference characters A2 to A5 designate word lines for selecting memory cells (Q21 to Q5n). Characters 1 to n designate drain voltage supply terminals. Characters S1 and S2 designate source voltage supply lines (as will be shortly referred to as "source lines"). The memory cells have their layout highly integrated by commonly arranging the sources and drains themselves of the plurality of memory cells, e.g., Q21, Q31, Q41 and Q51 in the row direction. Specifically, the memory cells Q21 and Q31 have their sources commonly connected, and the memory cells Q22 and Q32 arranged in another column and the memory cells Q2n and Q3n have their individual sources commonly connected, and these common sources are further commonly connected with the source voltage supply line S1. In the example shown in Fig. 1, the memory cells sharing the individual source voltage supply lines S1 and S2 are used as the minimum unit of the batch erasure block.

We have found out that the following problem arises in case the whole flash memory or a portion of the block is erased in a batch manner. Specifically, the erasure characteristics will disperse so much between the even and odd rows of the memory cells that a stable reading operation cannot be achieved. In short, the erasure characteristics will disperse between the even rows A2, A4, - - -, and so on and the odd rows A3, A5, - - -, and so on, as designated in Fig. 1. Incidentally, herein assumed is that the row direction means a direction in which the word lines coupled with the gates of the flash memory cells extends.

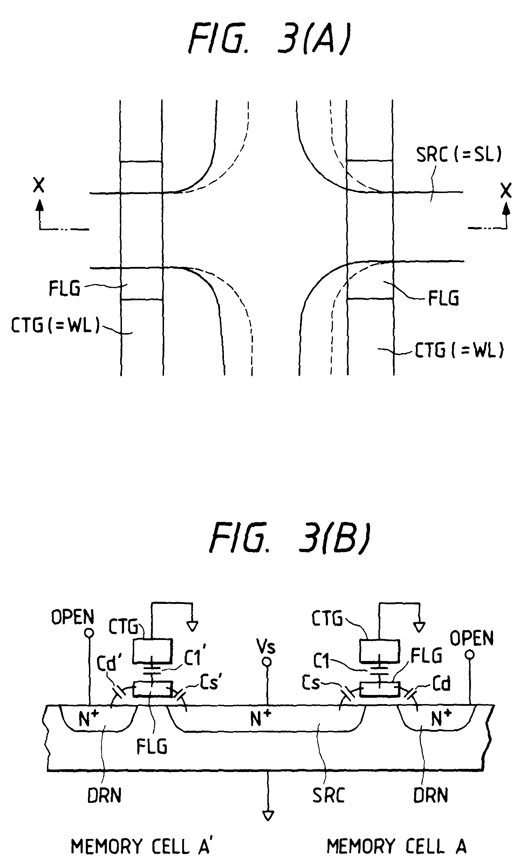

This principle is shown in Fig. 3. Fig. 3(A) is a top plan view showing a layout of two memory cells A and A' sharing the source lines, such as the memory cells Q21 and Q31 shown in Fig. 1, and Fig. 3(B) is a section taken along line X - X. In Fig. 3, the individual voltages to be applied to the source side tunnel regions at the erasing time are:

$$Vs - Vfg$$

$$\fallingdotseq \{Vs \cdot (C1 + Cd)/Ct\} + (Q/Ct) \qquad (1);$$

and

$$Vs - Vfg'$$

$$\fallingdotseq \{Vs \cdot (C1' + Cd')/Ct'\} + (Q'/Ct') \qquad (2);$$

wherein:

$$Ct = C1 + Cs + Cd;$$

$$Ct' = C1' + Cs' + Cd';$$

Q and Q':  the amounts of charges stored in the memory cells A and A'.

For simplicity, let the following relations be assumed: C1 = C1'; Cd = Cd'; and Q = Q' = 0, and the following relations are obtained:

$$Vs - Vfg$$

$$\fallingdotseq Vs \cdot (C1 + Cd)/(C1 + Cd + Cs) \qquad (3);$$

and

$$Vs - Vfg'$$

$$\fallingdotseq Vs \cdot (C1 + Cd)/(C1 + Cd + Cs') \qquad (4).$$

As shown in Fig. 3(A), a source line SL corresponding to the source SRC of the memory cell is rounded at its corner due to the characteristics of the semiconductor process. At this time, if the source line SL is positioned at the centers of the individual word lines WL of the memory cells A and A', as indicated by solid lines in Fig. 3(A), source coupling capacities Cs and Cs' are equal. In this case. the voltages to be applied to the source side tunnel regions of the memory cells A and A' are equalized by the formulas (3) and (4) so that the erasure characteristics are equal in the memory cells A and A'. On the other hand, in case the word line WL (or the floating gate FLG) and the source line SL mismatch in the photo mask so that the source line SL is arranged, as indicated by dotted lines in Fig. 3(A), the source coupling capacitance Cs of the memory cell A and the source coupling capacitance Cs of the memory cell A' takes a relation of Cs > Cs'. In this case, a relation of Vs - Vfg < Vs - Vfg' is derived from the foregoing formulas (3) and (4) so that the erasure characteristics of the memory cell A' are faster than those of the memory cell A. Incidentally, the control gate CTG, the inter-layer insulating film and the floating gate FLG of the memory cell can be formed in self-alignment by the dry etching or the like using the photo resist as the mask.

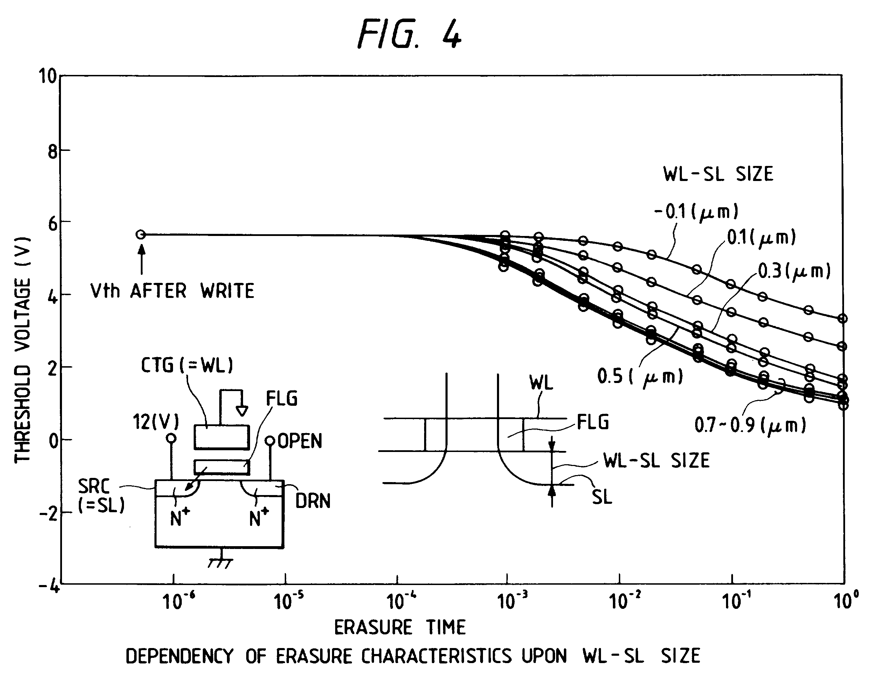

Fig. 4 presents the measured data verifying that the erasure characteristics depend upon the gap between the word line WL and the source line SL. As will be apparent from these data, the time period for achieving the predetermined erased state becomes the shorter for the larger distance between the word line WL and the source line SL. In other words, if the batch erasure is carried out when the source lines SL take an arrangement, as shown by broken lines in Fig. 3, the memory cell A takes a high threshold voltage, whereas the memory cell A' takes a low threshold voltage. If the threshold voltage is low with such dispersion, the memory cell may possibly be normally ON to cause a fatal defect. On the other hand, if the threshold voltage is high, there arises a problem that the memory cells cannot be accessed to when the supply voltage drops. In case the dispersion of the erasure characteristics in the memory cell array between the even rows and the odd rows is to be eliminated by layout means, the gap between the word lines can be enlarged in a manner to substantially ignore the dispersion of the source coupling capacitance of the adjoining memory cells sharing their source lines. In this case, however, it has to be accepted to reduce the degree of integration of the memory cells or to enlarge the size of the chip.

The present invention may seek to provide a flash memory which can stabilize or arrange the erasure characteristics of memory cells even with a dispersion in the source coupling capacitance of adjoining memory cells sharing their source lines. The present invention may also seek to provide a flash memory which can stabilize or arrange the erasure characteristics of the memory cells without reducing the degree of integration of the memory cells or enlarging the size of the chip. The present invention may also seek to provide a flash memory which can cope with the drop of the supply voltage easily. The foregoing and other aims and novel features of the present invention will become apparent from the following description and the accompanying drawings.

Accordingly, the present invention a nonvolatile memory device comprising:

a memory array (MARY) including a plurality of pairs of memory cells (Q), arranged in a matrix, of each of which pairs has a first memory cell and a second memory cell have their sources coupled to each other the first memory cells forming a plurality of rows of the matrix and the second memory cells forming another plurality of fors of the matrix, wherein each of said first and second memory cells has a drain, and a floating gate and a control gate over a channel region formed between said source and said drain;

a plurality of source lines (S1, S2) arranged in said memory array, wherein each of said plurality of source lines is coupled to said source of each of said paired memory cells;

a plurality of first word lines (WL1, WL3, WL5) and a plurality of second word lines (WL2, WL4) arranged in said memory array, wherein each one of said plurality of first word lines is coupled to said control gate of each of said first memory cells (Q1, Q2) of a corresponding row whereas each one of said plurality of second word lines is coupled to said control gate of each of said second memory cells (Q3, Q4) of ? corresponding; and

first voltage supply means (SS) for supplying a first erasing voltage to said source lines; characterised by

second voltage supply means (DRV) for selectively supplying a second erasing voltage to either said plurality of first word lines or said plurality of second word lines.

Examples of the present invention to be disclosed herein will be summarised in the following.

Specifically, of a pair of flash memory cells sharing their sources, only one memory cell is not erased before the other is erased. In view of the whole memory cell array or the block to be batch-erased, the flash memory cells on an even row (or an odd row) are erased at first, and the flash memory cells on the odd row (or the even row) are then erased. In other words, an erasure preventing voltage is applied to the odd row while the even row is being erased, and the erasure preventing voltage is applied to the even row while the odd or is being erased.

The aforementioned memory cell array can be divided into blocks having their source lines commonly connected. At this time, in order to further reduce the erasure dispersion at the time of erasing the whole face of the memory cell array, the whole face of the memory cell array may be erased sequentially at a block unit individually for the even and odd rows. If, moreover, it is considered that the data to be stored in the flash memory extend over a plurality of kinds such as a program, a data table or control data, only a selected block is desirably erased for the every even and odd rows.

In order to reduce the special control circuit for the erasing operations at the aforementioned even and odd units in case such flash memory is built in a data processor such as a microcomputer, such control may desirably be realized by making use of a central processing unit.

According to the means described above, if a pair of flash memory cells sharing their sources are to be erased two times for the individual sides, the difference in the capacitance coupling ratio between the sources and floating gates of the paired memory cells can be ignored to establish an drastically proper erased state for each of the paired flash memory cells sharing their sources. This establishment uniforms or stabilizes the erasure characteristics of the memory cell array as a whole.

The capability of reducing the dispersion of the threshold voltages after the erasure makes it possible to set the threshold voltages in the erase state to a relatively low level, which in turn makes it possible to raise the memory current at the read time thereby to make the low voltage reading operation of the flash memory possible.

Moreover, the erased state can be uniformed or stabilized even with a narrowed gap between the word lines and source lines thereby to reduce the flash memory size or the chip size.

In the drawings

Fig. 1 is a circuit diagram schematically showing a flash memory array sharing sources;

Fig. 2 is an explanatory diagram showing the ease, write and read voltage conditions of the flash memory cells together with a device structure;

Fig. 3(A) is a layout diagram showing two flash memory cells sharing their sources, and Fig. 3(B) is a section;

Fig. 4 is an explanatory diagram illustrating the dependency of the erasure characteristics upon the gap size between word lines and source lines;

Fig. 5 is a circuit diagram showing a portion of the flash memory array sharing the sources;

Fig. 6 presents explanatory diagrams showing examples of the voltage conditions when the even rows and the odd rows are separately erased and blocked from the erasures by making use of positive voltages;

Fig. 7 presents explanatory diagrams showing examples of the voltage conditions when the even rows and the odd rows are separately erased and blocked from the erasures by making use of positive and negative voltages;

Fig. 8 is a flow chart showing one example of the erase/verify processing procedure;

Fig. 9 is a block diagram showing one embodiment of the flash memory;

Fig. 10 is a circuit diagram showing one example of the memory cell array of the flash memory;

Figs. 11(A) and 11(B) present explanatory diagrams showing a voltage generator for generating a word line driving voltage;

Fig. 12 is a circuit diagram showing one example of an X-address decoder to which is applied a circuit for applying an erasing voltage and an erase blocking voltage selectively to the word lines;
Fig. 13 is a circuit diagram showing one example of the memory cell array which is divided into blocks as the batch erasure unit;
Fig. 14 is a flow chart showing one example of the erasing procedure for dividing each block into even words and odd words to erase them sequentially for the whole surface;
Fig. 15 is a block diagram showing one example of a flash memory for realizing the erasure by selecting a block to be erased and dividing it into even words and odd words;
Fig. 16 is a block diagram showing one embodiment of a microcomputer having the flash memory built therein;
Fig. 17 is an address map diagram showing one example of the microcomputer shown in Fig. 16; and
Fig. 18 presents diagrams showing control registers to be used for realizing the separate erasures of the even and odd words by a software control.

An embodiment of the present invention will be described sequentially in the order of the following items:

[1] Principle of Blocking Evenness-Oddness of Erasure Characteristics
[2] Embodiment of Flash Memory of Entire-Surface Batch Erasing Type
[3] Erasure Control at Even/Odd Word Line Unit
[4] Flash Memory of Batch Erasing Type at Block Unit
[5] Flash Memory of Block Selecting Batch Erasing Type
[6] Flash Memory Packaged Microcomputer

[1] Principle of Blocking Evenness-Oddness of Erasure Characteristics

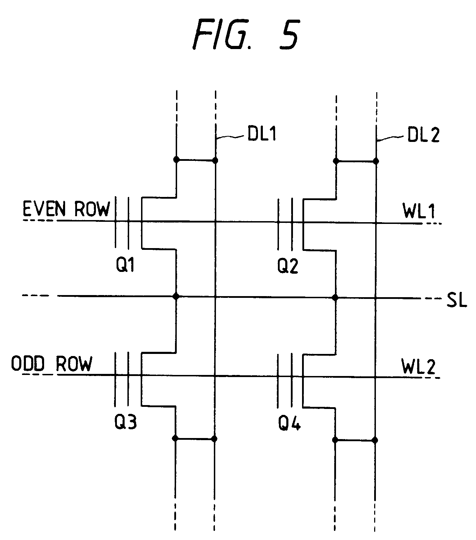

Fig. 5 shows the principle of the construction of a memory cell array using flash memory cells. Four memory cells Q1 to Q4 are representatively shown in Fig. 5. In the memory cells arranged in a matrix in X and Y directions, the memory cells Q1 and Q2 (or Q3 and Q4) arranged in the common row have their control gates (or the select gates of the memory cells) connected with individually corresponding word line WL1 (or WL2), and the memory cells Q1 and Q3 (or Q2 and Q4) arranged in the common column have their drains (or the input/output nodes of the memory cells) connected commonly with the individually corresponding data line DL1 (or DL2). The sources of the aforementioned memory cells Q1 and Q2 (or Q2 and Q4) are commonly connected with a source line SL. For convenience, it will be assumed that the word line WL1 falls on an even row whereas the word line WL2 falls on an odd row.

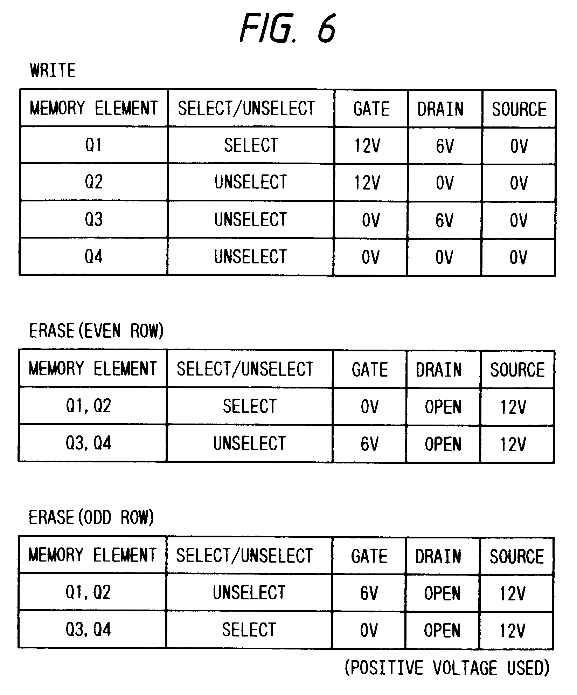

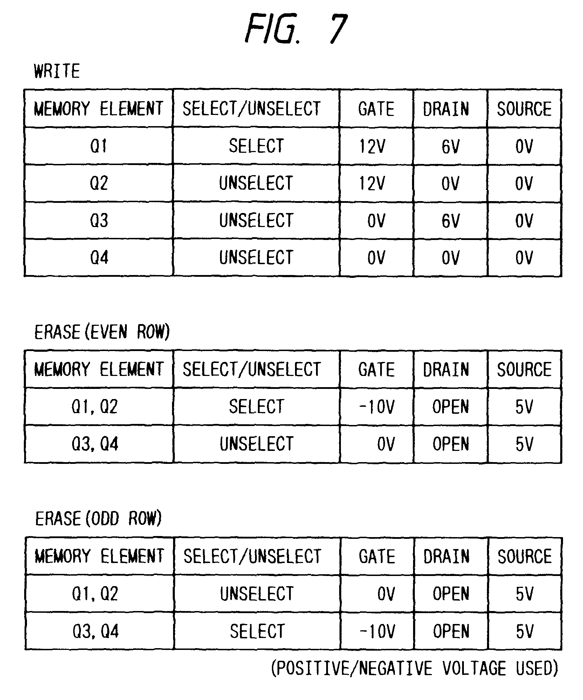

Fig. 6 enumerates one example of a voltage condition at the time of using a positive voltage for erasing and writing the memory cells. In Fig. 6, the "memory cell" means the memory cell, and the "gate" means the control gate acting as a memory cell selecting gate. In order to erase the memory cells sharing the source lines, as shown, at the unit of even or odd rows, a high electric field necessary for the erasure is generated by applying a voltage of 0 V to the gate of the memory cell to be erased, and a voltage of 6 V is applied to the gate of the memory cell to be blocked against the erasure. Fig. 7 enumerates one example of a voltage condition at the time of using positive and negative voltages for erasing and writing the memory cells. In order to erase the memory cells sharing the source lines, as shown, at the unit of even or odd rows, a high electric field necessary for the erasure is generated by applying a voltage of -10 V to the gate of the memory cell to be erased, and a voltage of 0 V is applied to the gate of the memory cell to be blocked against the erasure. In the batch-erasable block sharing the source lines, therefore, the batch erasure of even and odd rows at the unit of row can be effected by controlling the gate voltages at the unit of even and odd rows. Although the detail of this control will be described hereinafter, which of the even or odd row is to be erased can be designated either at a predetermined bit of a mode or address signal or sequentially in a predetermined order by a control logic circuit of the flash memory. In response to such designation, for example, the power supply of a word driver may be switched between the erase voltage such as 12 V and the erase block voltage such as 6 V.

The back erasure at the even or odd row unit will be described in more detail with reference to Fig. 1 to which is applied the construction of Fig. 5.
In case the data of a pair of memory cells Q21 and Q31 and other pairs of memory cells Q22 and Q32 and Q2n and Q3n, each of which shares its sources, on the row of a word line A2, are to be erased, a voltage of 0 V is applied at first to the word line A2, and the drain voltage supply terminals 1 to n are opened to apply a voltage of 12 V to a source voltage supply line S1 which is shared among the memory cells (Q21, Q22, - - -, and Q2n). On the other hand, a voltage of 6 V as high as about one half of the aforementioned erase voltage 12 V is applied to the source voltage supply line S1 so as to unselect memory the memory cells (Q31, Q32, - - -, and Q3n) on the row of a word line A3. The data of the memory cells on the row of the word line A2 are erased by that voltage relation.
With respect to a source voltage supply line S2, moreover, the erasure of the data of the memory cells on the row of a word line A4 can also be effected by a voltage relation similar to the aforementioned one and simultaneously with the case of erasing the data of the memory cells on the row of the word line A2.
Next, in case the data of the memory cells on the row of the word line A3 are to be erased, a voltage of 0 V is applied at first to the word line A3, and the drain voltage supply terminals 1 to n are opened to apply a voltage of 12 V to the source voltage supply line S1. In order to unselect the memory cells on the row of the word line A2 with respect to the source voltage supply line S1, on the other hand, a voltage of 6 V is applied to the word line A2. Thanks to this voltage relation, the data of the memory cells of the word line A3 are erased. With respect to a source voltage supply line S2, moreover, the erasure of the data of the memory cells on the row of a word line A5 can also be effected by a voltage relation similar to the aforementioned one and simultaneously with the case of erasing the data of the memory cells on the row of the word line A3.

The memory cells on the even rows of the word lines A2, A4, - - -, and so on are erased, as described above, and the memory cells on the odd rows of the word lines A3, A5, - - -, and so on are then erased. In case all the memory cells of the memory cell array are to be erased, they can be divided into those on the even rows and those on the odd rows and can be erased two times.

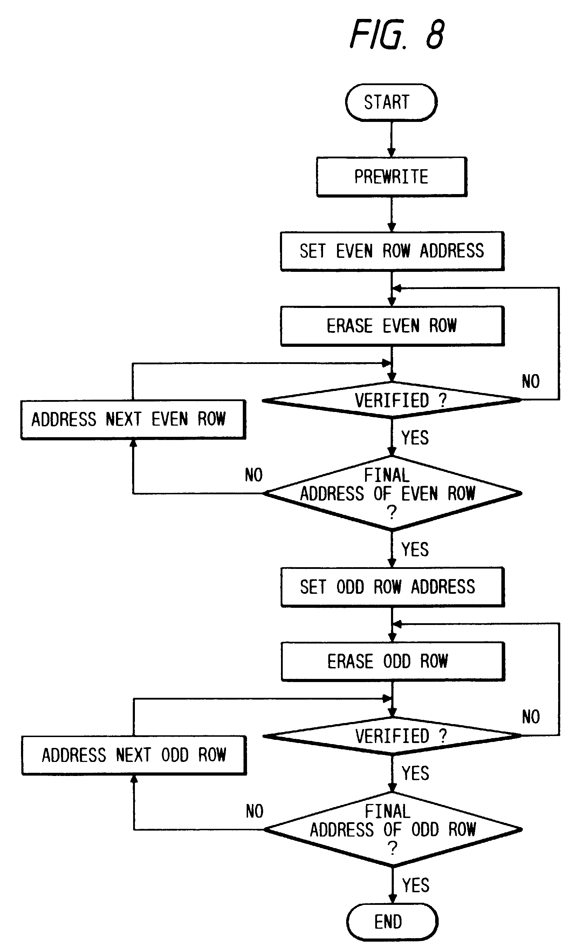

Next, the erase algorithm of the flash memory cells will be described with reference to Fig. 8. The erase algorithm to be described herein corresponds to the construction of Fig. 1, in which the sources of the memory cells of two rows are coupled to one source line. First of all, a prewrite is accomplished, in which identical data are written in all the memory cells. This prewrite step is carried out to uniform the amount of charge in the floating gates before erased for all bits thereby to uniform the erased states. Next, the address setting for erasing the even rows of the memory cell array is carried out. And, the memory cell data of the even rows selected according to the aforementioned address are erased. The time period for this erasure is shorter than that for which one erasure is ended. After this erasure, a verification is carried at the leading address of the even row. As a matter of fact, in order to prevent an excessive erasure from having the threshold voltage of the memory cells from taking a negative value, the erasures are gradually repeated for a short time such as 10 msecs while carrying out the verification each time. These erasures are repeated till the verification is answered by YES (i.e., the end of erasure). If YES, the routine transfers to the next even row address. The erasures and verifications described above are repeated till the verification of the final address of the even rows is answered YES. After the erasures of the even rows, addresses for the odd rows are set. After the erasures of the memory cell data of the odd rows selected according to the aforementioned address, the verification at the leading address of the odd rows is carried out. These erasures are repeated till the verification is answered by YES. If YES, the routine transfers to the next odd row address. The erasures of all the bits are ended by repeating the aforementioned erasures till the verification of the final odd row address is answered by YES. Incidentally, the algorithm described above can be likewise applied how many the number of the memory cells sharing one source light might be.

[2] Embodiment of Flash Memory of Entire-Surface Batch Erasing Type

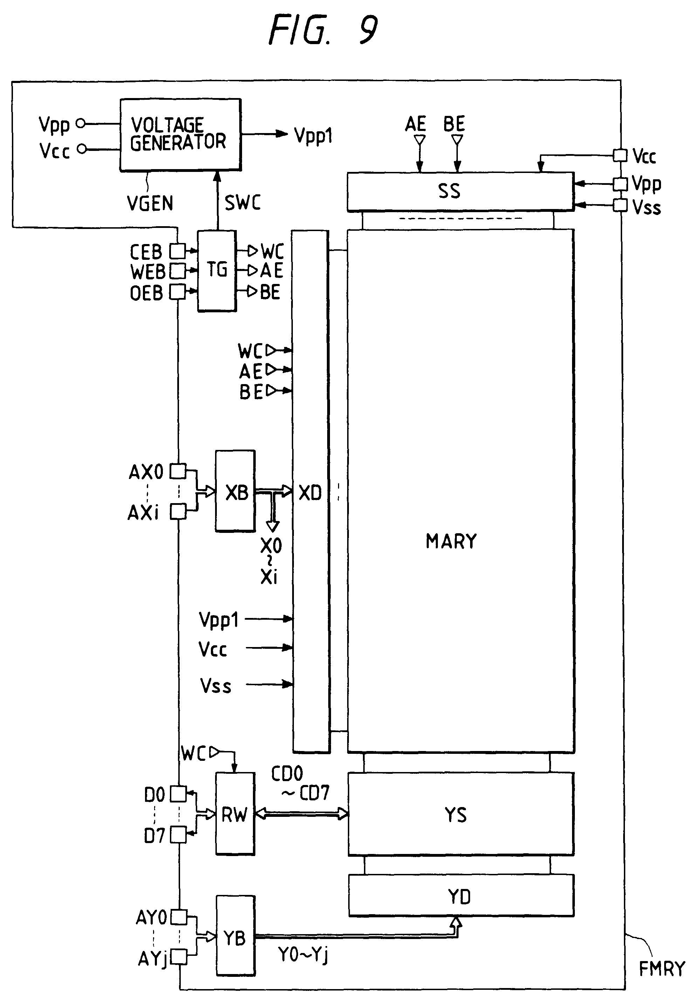

Fig. 9 is a block diagram showing one embodiment of the flash memory to which is applied the present invention. A flash memory FMRY of this embodiment is used as a memory for storing a program or fixed data, although not especially limited thereto.

In Fig. 9, the flash memory FMRY of this embodiment is formed over a single semiconductor substrate of single crystal silicon such that its most area is occupied by a memory cell array MARY. This memory cell array MARY includes: $(m + 1)$ word lines arranged in the horizontal direction of Fig. 9; $(n + 1)$ bit lines arranged in the vertical direction; and $(m + 1) \times (N + 1)$ flash memory cells (as will be shortly referred to as the "memory cells") arranged in matrix on the intersections between those word lines and bit lines.

The aforementioned individual memory cells are constructed of insulated gate type field effect transistors of the aforementioned two-layer gate structure and have their sources made of a common N-type diffusion layer and coupled to a source switch SS through source lines made of a predetermined aluminum wiring layer. The word lines composing the memory cell array MARY are coupled to the output of an X-address decoder SD and are selectively brought into selected states. The X-address decoder XD is fed with internal address signals X0 to Xi of $(i + 1)$ bits from an X-address buffer XB and internal control signals WC, AE and BE from a timing generator TG. On the other hand, the source switch SS is fed with the internal control signals AE and BE from the timing generator TG. The X-address buffer XB is fed with external address signals AX0 to AXi through the address input terminals.

Here, the internal control signal WC is selectively raised to a high level such as a power supply voltage Vcc when the flash memory is brought into the selected state in the write mode. Moreover, the internal control signal AE is selectively raised to the high level when the flash memory is brought into the selected state in the even row erase mode, and the internal control signal BE is selectively raised to the high level when the flash memory is brought into the selected state in the odd row erase mode. The timing generator TG is fed with a chip enable signal CEB, a write enable signal WEB and an output enable signal OEB as its external control signals. The operation modes such as the erase, write or read mode in the flash memory are determined in accordance with the combination of those signal levels so that the according internal control signals are fed to the individual portions in the flash memory FMRY from the timing generator TG.

The X-address buffer XB fetches and latches the X-address signals AX0 to AXi fed through its address input terminals and produces the internal address signals X0 to Xi on the basis of those X-address signals to feed them to the X-address decoder XD. This X-address decoder XD decodes the internal address signals X0 to Xi fed from the X-address buffer XB to bring the corresponding word lines of the memory cell array MARY selectively into the selected states at the high level. In this embodiment, the unselected level of the word lines are set to 0 V, i.e., a ground potential Vss. On the other hand, the selected level of the word lines is set to a supply voltage Vpp such as +12 V when the flash memory is brought into the write mode to raise the internal control signal WC to the high level. When the flash memory is brought into the read level to drop the internal control signal WC to the low level, the selected level of the word lines is set to the supply voltage Vcc such as +5 V. When the internal control signal AE is given the high level whereas the internal control signal BE is given the low level, the flash memory is set in the even row erase mode, and an erasure voltage such as 0 V is applied as the ground potential Vss to the even row word lines, and an erasure preventing voltage such as 6 (V) is applied to the odd row word lines from the X-address decoder XD. When the internal control signal AE is given the low level whereas the internal control signal Be is given the high level, the flash memory is brought into the odd row erasure mode, and the erasure voltage such as 0 V is applied as the ground potential Vss to the odd row word lines, whereas the erasure preventing voltage such as 6 (V) is applied to the odd row word lines from the X-address decoder XD. A voltage for driving such word lines is generated by a voltage generator VGEN.

On the other hand, the source switch SS feeds the supply voltage Vpp such as a source voltage at a relatively high potential of 12 V selectively to the source when the internal control voltage AE or BE is at the high level. The block, to which no erasure is designated when the flash memory is in the write or read mode or in the erase mode, is fed with a source voltage of a lower potential such as the ground potential Vss.

The (n + 1) bit lines composing the aforementioned memory cell array MARY are coupled to a Y switch YS, and the eight bit lines designated by the address are selectively connected through that Y switch YS with common data lines CD0 to CD7. The Y switch YS is fed with bit line select signals from a Y-address decoder YD. On the other hand, this Y-address decoder YD is fed with internal address signals of (j + 1) bits from a Y-address buffer YB, which in turn are fed with external Y-address signals AY0 to AYj through the address input terminals. The Y-address buffer YB fetches and latches the external Y-address signals AY0 to AYj fed through the address input terminals and produces the internal address signals Y0 to Yj on the basis of those Y-address signals to feed them to the Y-address decoder YD> This Y-address decoder YD decodes the internal address signals Y0 to YJ fed from the Y-address buffer YB to raise the corresponding bit line select signals selectively to the high level. The Y switch YS includes an n number of switch MOSFETs which are provided to correspond to the individual bit lines of the memory cell array MARY.

Every eight of those switches MOSFETs are selectively turned on when the bit line select signals are selectively raised to the high level, to connect the corresponding eight bit lines of the memory cell array MARY and the common data lines CD0 to CD7 selectively.

The common data lines CD0 to CD7 are coupled to the corresponding unit circuits of a read/write circuit RW. This read/write circuit RW includes eight unit circuits corresponding to the common data lines CD0 to CD7. Each unit circuit includes one write amplifier and one read amplifier. The write amplifiers constituting the individual unit circuits of the read/write circuit RW are selectively brought into an operating state if the flash memory is brought into the write mode so that the internal control signal WC is raised to the high level. In this operating state, the individual write amplifiers produce predetermined write signals on the basis of the write data fed through the corresponding data input/output terminals D0 to D7 and write them in the selected eight memory cells of the memory cell array MARY through the common data lines CD0 to CD7. Incidentally, the high level of the write signals fed from the read/write circuit RW through the common data lines CD0 to CD7 to the selected memory cells has its high level set to a voltage such as +6 V dropped from the supply voltage Vpp and its low level set to the ground potential Vss, i.e., 0 V. On the other hand, the read amplifiers constituting the individual unit circuits of the read/ write circuit RW are selectively brought into the operating state, when the flash memory is in the read mode, to amplify the read signals, which are outputted from the selected eight memory cells of the memory cell array MARY through the common data lines CD0 to CD7, and to output them through the data input/output terminals D0 to D7. At this time, the read amplifiers feeds a predetermined bias voltage such as +1 V to the selected memory cells of the memory cell array MARY.

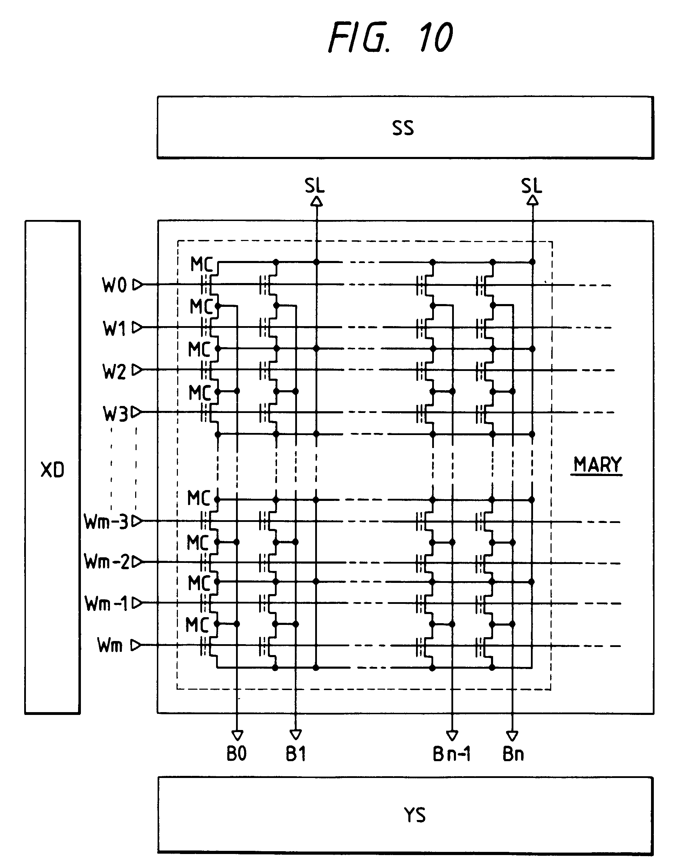

Fig. 10 is a circuit diagram showing the memory cell array MARY in the flash memory of Fig. 9. In Fig. 10, reference letters MC designate memory cells, letters W0 to Wm designate word lines; letters B0 to Bn designate bit lines; and letters SL designate source lines. The individual source lines are provided at the unit of the memory cells MC of vertical eight columns, although not especially limited thereto. The source lines extending in the longitudinal of Fig. 10 are made of aluminum, and the source lines connected vertically with the aluminum source lines are made of a diffusion layer. All of these individual source lines SL have their voltages controlled to an equal level. In other words, the erasures in the flash memory of the present embodiment are carried altogether all over the surface for even and odd words of the memory cell array MARY.

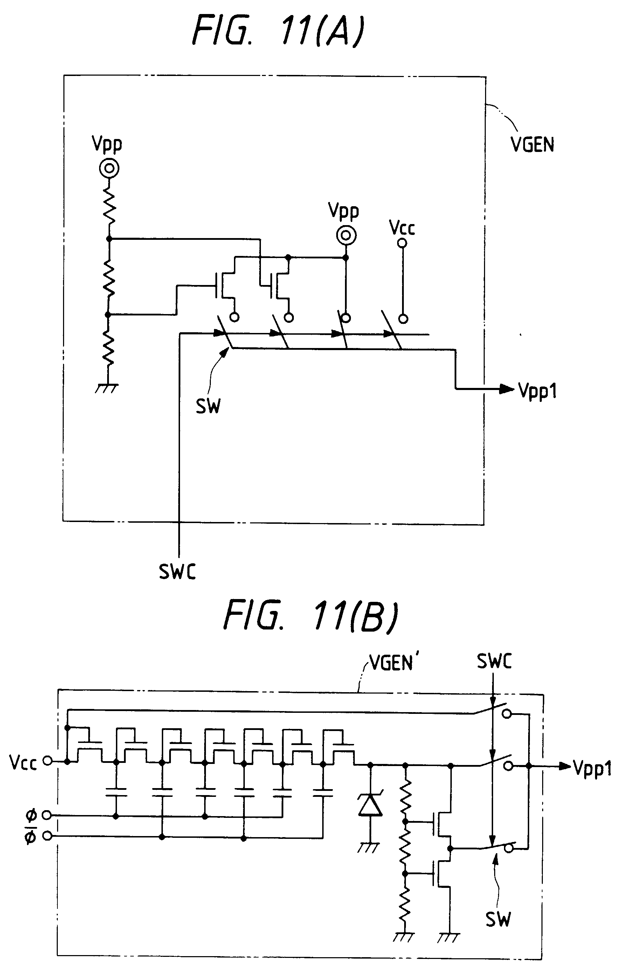

Fig. 11(A) is a circuit diagram showing one example of the aforementioned voltage generator VGEN shown in Fig. 9. The circuit, as shown in Fig. 11(A), biases a MOS resistor with the voltage, which is obtained by dividing the high voltage Vpp such as 12 V resistively, to produce an erasure blocking voltage such as 6 V and selects this erasure blocking voltage, the high voltage Vpp and the supply voltage Vcc exclusively by means of a switch SW to output the selected voltage as a word line driving voltage Vpp1. Fig. 11(B) is a circuit diagram showing one example of a voltage generator VGEN'. This voltage generator VGEN' is a circuit for establishing a similar word line driving voltage Vppl by boosting the supply voltage Vcc by means of a charge pump circuit which is fed with clutch pulses $\phi$ and $\phi$ (wherein the pulse $\phi$ indicates the inverted level of the pulse $\phi$). The switch SW, as shown in Figs. 11(A) and 11(B), is controlled by the control signal, which is produced on the basis of the output control signal of the aforementioned timing generator TG, to select a voltage level according to the internal operation mode.

[3] Erasure Control at Even/Odd Word Line Unit

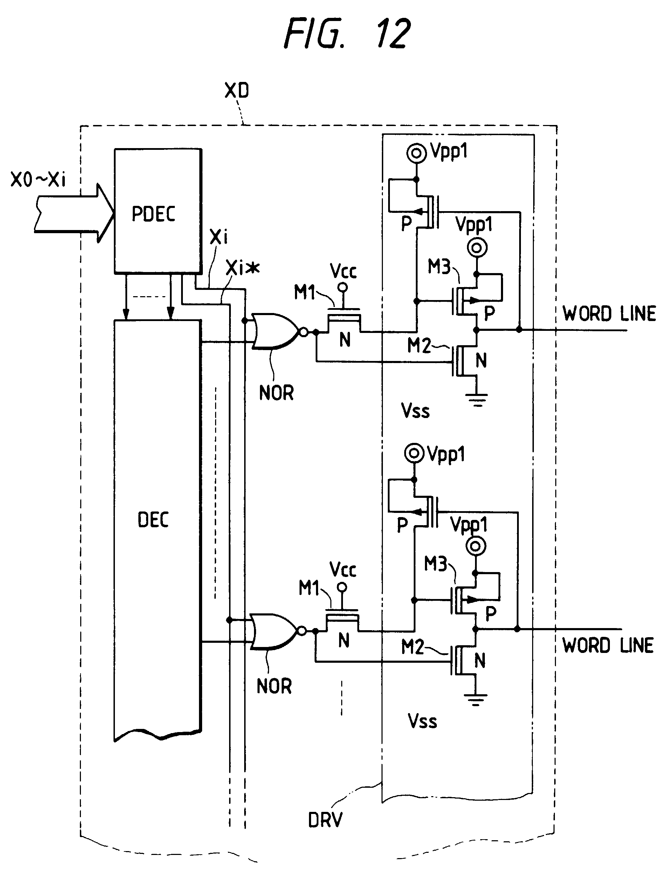

Here will be described one example of the erasure at the even or odd word line. Fig. 12 shows one example of the aforementioned X-address decoder XD. A construction corresponding to two word lines is representatively shown in Fig. 12. The X-address signals X0 to Xi are composed of: a predecode circuit PDEC; a decode circuit DEC for decoding the output of the predecode circuit; a plurality of (equal to the number of word lines) NOR gates NOR made receptive of a predetermined output of the predecode circuit PDEC and a predetermined output of the decode circuit DEC; and a drive portion DRV for driving the word lines on the basis of the outputs of the NOR gates NOR. The predecode circuit PDEC and the decode circuit DEC are operated by the supply voltage Vcc such as a system of 5 V. The drive portion DRV is a high voltage drive system which is driven by a voltage such as the aforementioned voltage Vpp1. Reference characters M1 designate a high voltage resisting N-channel MOS transistor for isolating the 5 V system and the high voltage system. When the output of the NOR gate NOR is at the high level, the corresponding word line is driven to the ground potential Vss such as 0 V through a transistor M2. When the output of the NOR gate NOR is at the low level, the corresponding word line is driven to the voltage Vpp1 through a transistor M3.

Of the outputs of the decode circuit DEC, the signal corresponding to the word line to be selected is set to the low level. In the read mode and write mode, one output signal corresponding to the address signals AX0 to AXi is set to the low level. In the erase mode, all the output signals are set to the low level. The signals to be fed from the predecode circuit PDEC to the NOR gate NOR is internal complementary address signals Xi and Xi* (symbol * indicates the inversion of level or phase from the signal having the symbol) corresponding to the address bit AXi, although not especially limited thereto. The address bit AXi is deemed as a bit for designating which of the even number word lines (i.e., even word lines) or the odd number word lines (i.e., odd word lines) are to be batch-erased for batch-erasing the memory cells. As a result, when the signal Xi is at the low level in the erase mode whereas the signal Xi* is at the high level, the odd word lines are driven to 0 V whereas the odd word lines are driven to Vpp1 so that the memory cells on the even word lines of the memory cell array MARY can be erased whereas the memory cells on the odd word lines of the memory cell array MARY are blocked from the erasure. On the other hand, when the signal Xi is at the high level whereas the signal Xi* is at the low level, the even word lines are driven to Vpp1 whereas the odd word lines are driven to 0 V so that the memory cells of the odd word lines of the memory cell array MARY can be erased whereas the memory cells of the even word lines of the memory cell array MARY are blocked from the erasure. Incidentally, in the erase mode, the voltage Vppl is set to the erasure blocking voltage such as 6 V.

The algorithm of the erasure verification based upon the control described above will be explained with reference to Fig. 8. First of all, the erasure control signal is fetched from the outside to the inside. Next, the prewrite is carried out. This prewrite converges and arranges the threshold voltages of the memory cells after the erasure. After the end of the prewrite, the routine transfers to the sequence of erasing/verifying the odd rows. At first, the even rows have their addresses set and are erased. At this time, the word lines of the odd rows are supplied with the voltage Vpp1 at the erasure preventing voltage such as 6 V. The first address is read (or verified). If the threshold voltage of the memory cells is in the erase state, the address of the next even row is read. The erasure/verify sequence is repeated till a bit of insufficient erasure is found. If this bit of insufficient erasure is hit, the erasure is carried out for a constant time period, and the read is carried out from the same address. These steps are repeated till the final address of the even row is reached. Next, the routine transfers to the erase/verify sequence of the odd rows. At this time, the even rows are supplied with the erasure preventing voltage.

[4] Flash Memory of Batch Erasing Type at Block Unit

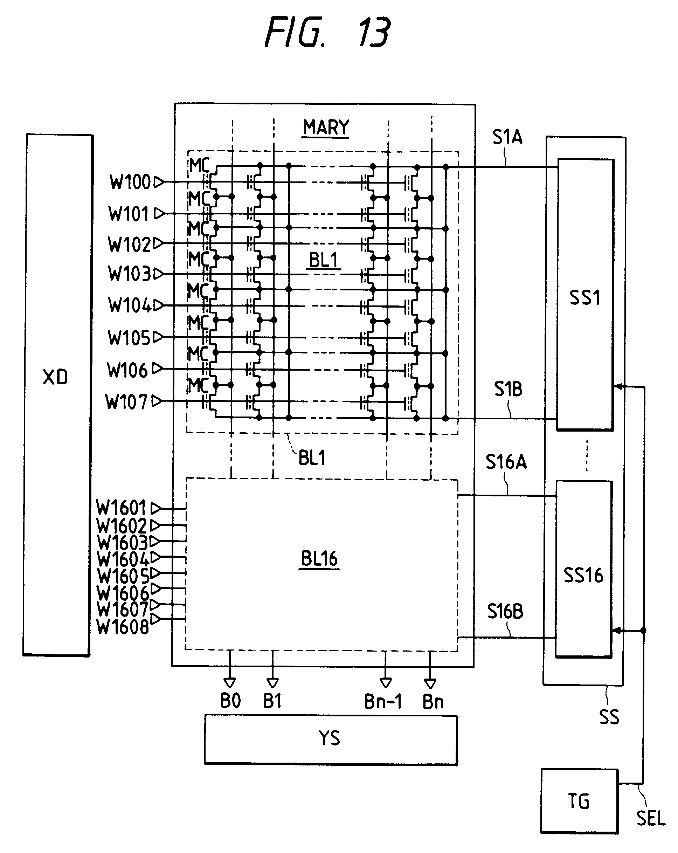

Fig. 13 shows the memory cell array MARY in the flash memory of batch erasing type at a block unit. As shown, the memory cell array MARY is divided into sixteen blocks as the batch erasure unit. Since these sixteen blocks BL1 to BL16 are individually the batch erasure units, the source lines are separated for the individual blocks BL1 to BL16. Reference characters S1A and S1B, as shown representively, designate the mutually connected source lines of the block BL1, and characters S16A and S16B designate the mutually connected source lines of the block BL16. Moreover, the source switch SS is equipped with source division switches SS1 to SS16 corresponding to the divided blocks. When one of these source division switches SS1 to SS16 is selected in response to a select signal SEL coming from the timing genrator TG so that the internal control signal AE or BE is set to the high level, the supply voltage Vpp is fed to the source line which is coupled to the source division switch selected. The ground potential Vss is fed to the source line which is coupled to the block left undesignated the erase in the erase mode (i.e., the source division block unselected).

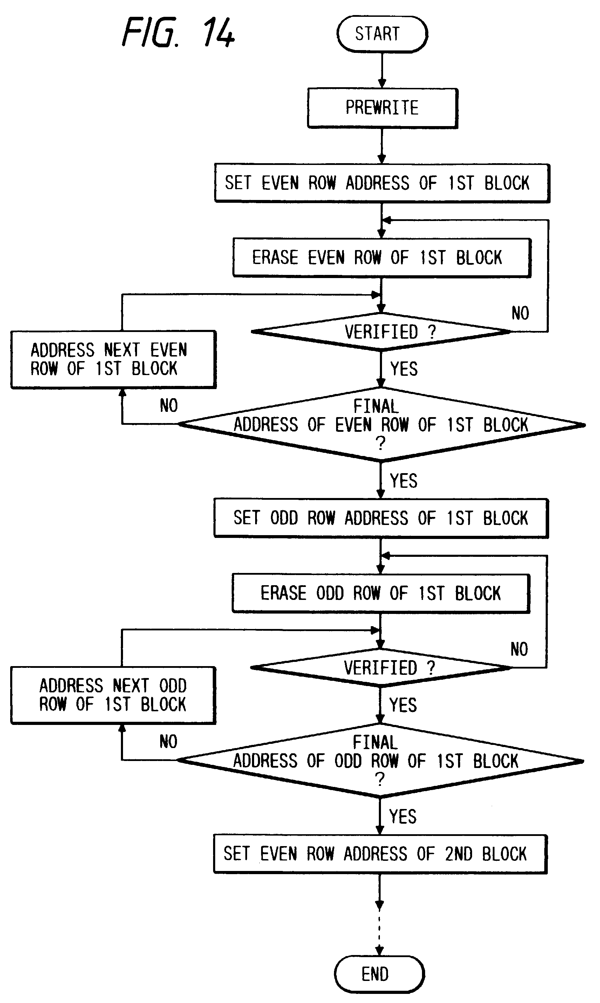

In case of these block divisions, the erasures can be sequentially carried out at the unit of blocks. The procedure of the erasure of the whole surface of the memory cell array MARY is shown in Fig. 14, the even word lines and the odd word lines are divided at the block unit, and the batch erasure is carried out at the block unit. Specifically, the erasure of the even rows of the first block BL1 is carried out after the prewrite. At this time, the erasure preventing voltage is applied to the odd rows of the first block BL1 and to other blocks. After the end of the erasure of the even rows of the first block BL1, the odd rows of the first block BL1 are erased. At this time, the erasure preventing voltage is applied to the even rows of the first block BL1 and the remaining blocks BL2 to BL16. After the erasure of the first block BL1, the even rows of the second block BL2 are erased, and similar steps are repeated till the block BL16. In this description, the erasure is carried out at the block unit sequentially from the first block BL1. If, however, the erasures of the even rows of the individual blocks are simultaneously started so that a standby or an erasure of the odd rows is started from the block having its erasure ended, the erasure time period can be shortened. Thanks to the erasures by dividing the memory cell array MARY into the blocks, it is possible to reduce the dispersion of the erasures more than the batch erasure of the whole surface. In the whole surface erasure at the block unit, all the blocks may be erased together at first for a constant time period, not at the block unit as described above, and the erasures may then be carried out at the block unit separately for the even word lines and the odd word lines. Thus, the efficiency of the batch erasure can be improved better than the aforementioned method.

[5] Flash Memory of Block Selecting Batch Erasing Type

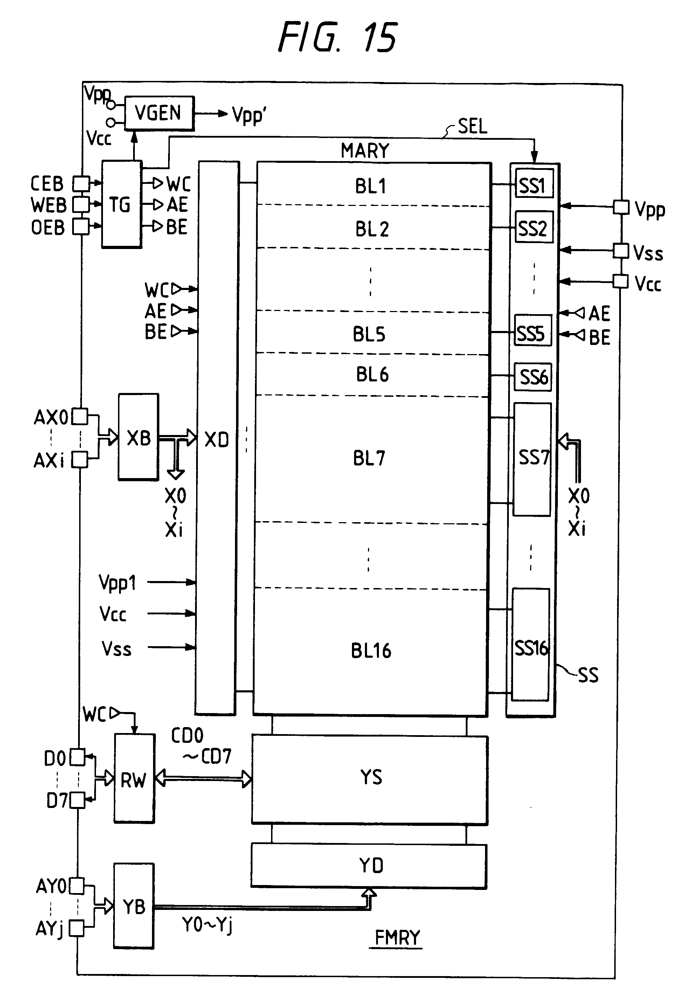

Fig. 15 shows an embodiment of the flash memory capable of select and back-erase a desired block. The construction of the memory cell array MARY in this case is made similar to that of Fig. 13 excepting the storage capacities of the individual blocks. Specifically, the blocks BL1 to BL6 are made relatively small whereas the blocks BL7 to BL16 are made relatively large. In other words, the number of the memory cells contained in each of the blocks BL1 to BL6 is smaller than that of the memory cells contained in each of the blocks BL7 to BL16. The memory cells of each block have their sources made of a common N-type diffusion layer but independently of the sources of the memory cells composing another block and coupled to the source switch SS through the source lines S1A and S1B to S16A and S16B made of a predetermined aluminum wiring layer. As a result, the individual blocks can be selectively supplied with different source voltages through the corresponding source lines so that the stored data can be erased/written, i.e., reloaded at the block unit. In case the block BL1 is to be erased, the source lines S1A and S1B are set to +12 V by the source switch SS, and the source lines of the unselected blocks are left at the ground potential Vss. At this time, the selected block erases the even rows and then the odd rows. Incidentally, the selection of the block to be erased is carried out with the predetermined 4 bits of the address signals X0 to Xi by the source switch SS.

[6] Flash Memory Packaged Microcomputer

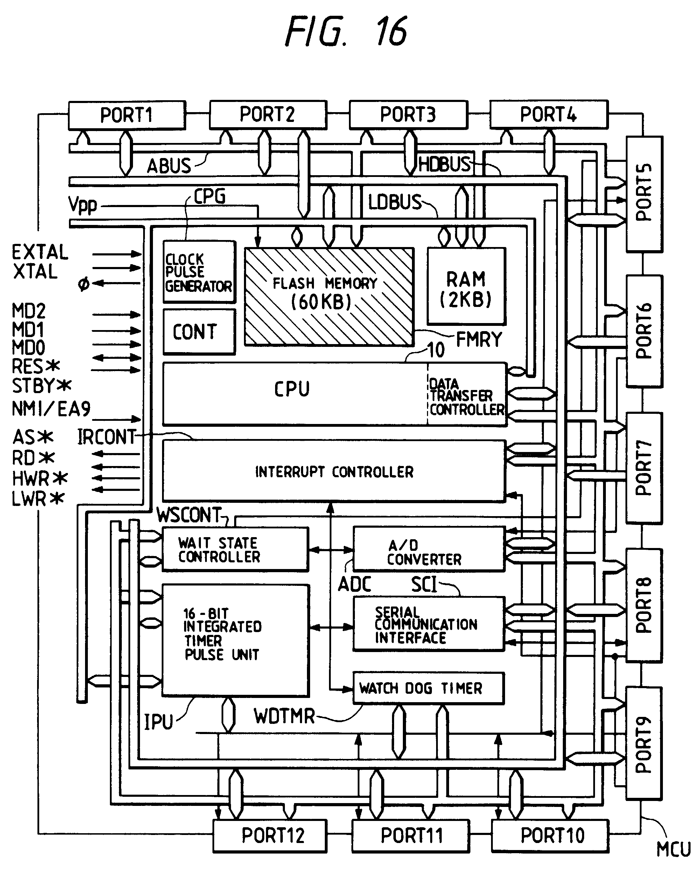

Fig. 16 is a block diagram showing an embodiment of the microcomputer having the aforementioned flash memory packaged therein. The microcomputer MCU, as shown in Fig. 16, is constructed of a central processing unit CPU, a flash memory FMRY, a serial communication interface SCI, a control circuit CONT, a random access memory RAM, a 16-bit integrated timer pulse unit IPU, and a watch dog timer WDTMR. The microcomputer MCU is further equipped with ports PORT1 to PORT12 corresponding to the input/output circuits. The microcomputer MCU is further equipped as its other functional blocks with a clock pulse generator CPG, an interrupt controller IRCONT, an analog/digital converter ADC, and a wait state controller WSCONT. The central processing unit CPU, flash memory FMRY, random access memory RAM and 16-bit integrated timer pulse unit IPU described above are connected with an address bus ABUS, a lower data bus LDBUS (of 8 bits, for example) and a higher data bus HDBUS (of 8 bits, for example). The serial communication interface SCI, watch dog timer WDTMR, interrupt controller IRCONT, analog/digital converter ADC, wait state controller WSCONT and ports PORT1 to PORT12 described above are connected with the address bus ABUS and the higher data bus HDBUS. The aforementioned flash memory FMRY is used for storing the program and the fixed data, although not especially limited thereto. The circuit elements composing the individual blocks shown in Fig. 16 are formed over a single semiconductor substrate of single crystal silicon together with not-shown other circuit elements composing the microcomputer.

In Fig. 16, reference letters Vpp designate a reloading high voltage of the flash memory FMRY. Letters EXTAL and XTAL designate signals to be fed to the aforementioned clock pulse generator CPG from the not-shown oscillators which are attached to the outside of the chip of the microcomputer. Letter $\phi$ designates a synchronous clock signal to be outputted from the clock pulse generator CPG to the outside. Letters MD0 to MD2 designate mode signals to be fed to the control circuit CONT so as to set the operation modes of the microcomputer. Letters RES* and STB* designate a reset signal and a standby signal, respectively, which are fed to the central processing unit CPU and other circuit blocks. Letters NMI designate a non-maskable interrupt signal for feeding an non-maskable interrupt to the aforementioned interrupt controller ICONT. The not-shown other interrupt signals are fed through the ports PORT8 and PORT9 to the interrupt controller ICONT. Letters AS* designate an address strobe signal indicating the validity of the address signal to be outputted to the outside; letters RD* designate a read signal informing the outside of the read cycle; letters HWR* designate an upper byte write signal for informing the outside of the write cycle of higher 8 bits; and letters LWR* designate a lower byte write signal for informing the outside of the write cycle of lower 8 bits. All of these signals are used as access control signals for the outside of the microcomputer MCU.

In the single flash memory of the embodiment thus far described, the erase/write controls are carried out by the timing generator. On the other hand, in case of the package in the microcomputer, as in the present embodiment, the erase/write of the flash memory can be controlled by the software of the CPU.

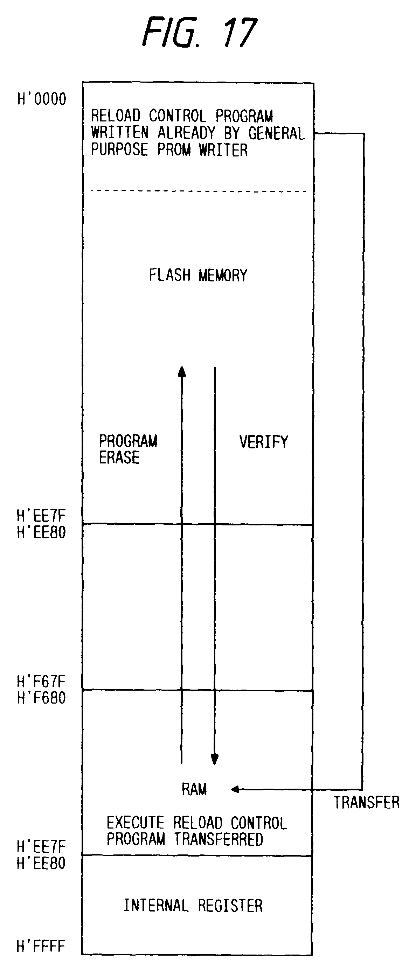

For example, Fig. 17 shows a memory map of the microcomputer of the present embodiment. In Fig. 17, the flash memory FMRY has its predetermined region prewritten with a reload control program and a transfer control program. When a reload mode is designated the central processing unit CPU execute the reload control program and transfers the reload control program to the random access memory RAM. After the end of transfer, the processing of the central processing unit CPU is branched to the execution of the reload control program on the random access memory RMA, whereby the erase and write (including the verify) of the flash memory FMRY are repeated. The aforementioned CONT is a control circuit for executing the selecting controls of the various timings and voltages for the reading, writing and erasing operations of the data in the flash memory.

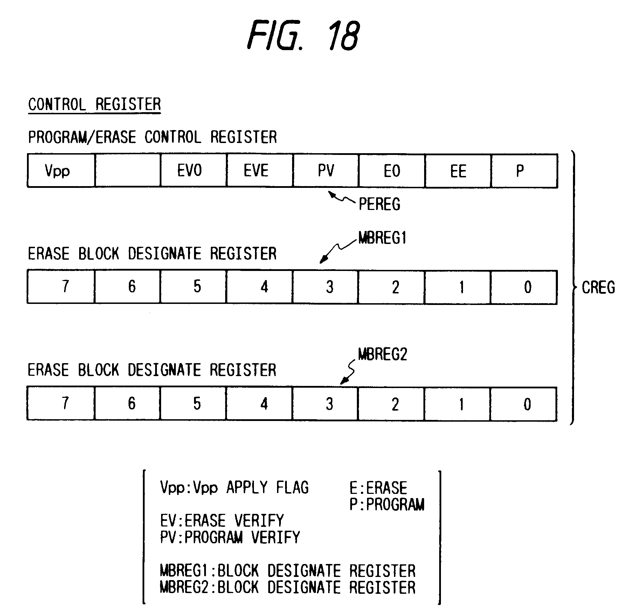

The aforementioned control circuit CONT is equipped with a control register CREG, as shown in Fig. 18. This control register CREG is constructed of a program/erase control register PEREG and erase block designate registers MBREG1 and MBREG2 individually of 8 bits. In the program/erase control register PEREG, letters Vpp designate a high voltage apply flag to be set to "1" in response to application of the reloading high voltage. An EE bit is used to designate the erasing operation of even rows; an EO bit is used to designate the erasing operation of odd rows; an EVE bit is used to designate the verification of even rows; and an EVO bit is used to designate the verification of odd rows. A P bit is used to designate the writing operation (or the program operation), and a PV bit is used to designate the verification in the writing operation. The erase block designate registers MBREG1 and MBREG2 are used to designate what of the memory block contained in the sixteen divided blocks is to be erased. For example, the value "1" means the selection of the corresponding memory block, and the bit "0" means the non-selection of the corresponding memory block. For example, if the erase block designate register MBREG2 has its seventh bit at "1", the source division switch SS16 is selected so that the erasure of the memory block ML16 is designated. In the erasure using this control register CREG, the central processing unit CPU outputs the address signals and the various control signals and executes its processing with the procedure according to the reload control program while repeating the write of and reference to the control register CREG. The basic erase procedure is similar to that of the foregoing embodiment, and the central processing CPU prewrites the memory cells within the address ranges to be erased, in accordance with the aforementioned reload control program. As a result, all the states of the memory cells before the erasure are arranged to the write state. Next, for the memory cells to be erased, the degree of erasure is verified (i.e., erase/verify) while the erasure being executed bit by bit, so that the erasure may be ended while preventing the excessive erasure. At this time, the controls for erasing the even row word lines and the odd row word lines follow the EE bit and EO bit of the control register CREG. For example, if the erasure is designated, the central processing unit CPU initially sets the EO bit to "1" and the EE bit to "0" to erase/verify the odd row word lines of the block to be erased. After this, the central processing unit CPU reloads the EO bit to "0" and the EE bit to "1" to erase/verify the even row word lines of the block to be erased. If the odd row word lines are to be erased, the central processing unit CPU feed the flash memory FMRY with the address signals for setting the signal Xi to the high level and the signal Xi* to the low level, as has been described with reference to Fig. 12. If the even row word lines are to be erased, the central processing unit feeds the flash memory FMRY with the address signals for setting the aforementioned signal Xi to the low level and the aforementioned signal Xi* to the high level. Incidentally, in case a block to be erased is to be designated by using the control register CREG, the source switch SS, as shown in Fig. 15, is equipped with the source division switches in each block, as in Fig. 13, and is fed with the values of the erase block designate registers MBREG1 and MBREG2 to apply the erasing voltage Vpp and the erasure preventing voltage Vss to the source lines of the batch erase block.

In case, moreover, the microcomputer is connected with an external device such as a PROM writer to make the erase/write possible so as to enhance the first data writing efficiency, the reload mode by such PROM writer can be designated with the aforementioned mode signals MD0 to MD2. If such reload is designated, for example, the aforementioned control circuit CONT designates an I/O port to be interfaced with the PROM writer thereby to make the built-in flash memory FMRY directly accessible by the external PROM writer. The reload control at this time can be realized according to a reload control program like before by decoding the command, which is written from the PROM write in the microcomputer, by the central processing unit CPU.

Although our invention has been specifically described in connection with the embodiments thereof, it should not be limited thereto but can naturally be modified in various manners without departing from the gist thereof. For example, the separate erasures of the even word lines and the odd word lines need not be carried out from the beginning. Specifically, due to the characteristics of adopting the erasing procedures in which the stepwise erase and and erase/verify are repeated from the standpoint of preventing the excessive erasure, the erasure is carried out not separately at the first stage for the even word lines and the odd word lines but separately in the course of erasure. According to this modification, the batch erasure can be made efficient while suppressing the dispersion of the erasure characteristics.

In the description thus far made, the present invention has been described in case it is applied to either a single flash memory according to the field of application backgrounding the invention or a microcomputer having the flash memory built therein, but the present invention can be widely applied to other data processors. The present invention can be applied to a data processor which is conditioned such that a pair of flash memories sharing at least their sources are arranged in matrix.

The effects to be achieved from a representative one of the invention disclosed herein will be briefly described in the following.

(1) Since the paired flash memory cells sharing their sources are separately erased two times, the difference in the capacitance coupling ratio between the sources and floating gates of the paired flash memory cells can be ignored so that the paired flash memory cells sharing the sources can be separately brought into drastically proper erased states. As a result, the erasure characteristics of the whole memory cell array can be uniformed or stabilized.

(2) Thanks to the aforementioned effect, the dispersion of the threshold voltages after the erasure can be minimized to set the threshold voltage of the write state at a relatively low level so that the memory current to be taken at the reading time can be made high to cope with the reading operation of the flash memory at a low voltage.

(3) Thanks to the aforementioned effect, the erased state can be uniformed or stabilized, even if the gap between the word lines and the source lines is shortened, to reduce the size of the flash memory cells or the chip.

(4) The inside of the memory cell array is divided into the blocks or batch erase units having their source lines commonly connected, and the whole face of the memory cell array is sequentially erased at the block unit individually for the even and odd rows, so that the dispersion of the erasure can be further reduced at the time of the whole erasure of the memory cell array.

(5) If it is considered that the data to be stored in the flash memory extend over a plurality of kinds such as the program, the data table or the control data, the usability of the flash memory on the board or system can be improved because only the selected block can be erased for every even and odd rows.

(6) Since the erasure control at the units of such even and odd rows for the flash memory packaged in a data processor such as the microcomputer is realized by the central processing unit and its operation program, a control circuit especially for the erasure can be reduced.

## Claims

1. A nonvolatile memory device comprising:

   a memory array (MARY) including a plurality of pairs of memory cells (Q), arranged in a matrix, of each of which pairs has a first memory cell and a second memory cell with their sources coupled to each other the first memory cells forming a plurality of rows of the matrix and the second memory cells forming another plurality of rows of the matrix, wherein each of said first and second memory cells has a drain, and a floating gate and a control gate over a channel region formed between said source and said drain;
   a plurality of source lines (S1, S2) arranged in said memory array, wherein each of said plurality of source lines is coupled to said source of each of said paired memory cells;
   a plurality of first word lines (WL1, WL3, WL5) and a plurality of second word lines (WL2, WL4) arranged in said memory array, wherein each one of said plurality of first word lines is coupled to said control gate of each of said first memory cells (Q1, Q2) of a corresponding row whereas each one of said plurality of second word lines is coupled to said control gate of each of said second memory cells (Q3, Q4) of another corresponding row; and
   first voltage supply means (SS) for supplying a first erasing voltage to said source lines; characterised by
   second voltage supply means (DRV) for selectively supplying a second erasing voltage to either said plurality of first word lines or said plurality of second word lines.

2. A nonvolatile memory device according to claim 1, further comprising control means (TG) for outputting one of first and second control signals to said second voltage supply means (DRV).

3. A nonvolatile memory device according to claim 2, wherein when said control means (TG) outputs said first control signal, and second voltage supply means supplies said second erasing voltage to said plurality of first word lines (WL1,WL3, WL5) and an erasure preventing voltage to said second plurality of second word lines (WL2, WL4), and wherein when said control means outputs said second control signal, said second voltage supply means supplies said second erasing voltage to said plurality of second word lines and an erasure preventing voltage to said plurality of first word lines.

4. A nonvolatile memory device according to claim 3, wherein said first voltage supply means (SS) includes a plurality of voltage supply circuits, wherein one of said voltage supply circuits selected in accordance with a select signal coming from said control means (TG) feeds said first erasing voltage.

5. A nonvolatile memory device according to claim 4, further comprising a register (CREG) having: an erase designating bit for designating an erasing operation; a write designating bit for designating a write operation; a verify designating bit for designating a verifying operation; an erase block designating bit for designating at least one of said source lines to be coupled to the memory cells to be erased.

6. A nonvolatile memory device according to claim 5, wherein said first voltage supply means (SS) includes a plurality of voltage supply circuits, wherein one of said voltage supply circuits selected in accordance with the erasure block designating bit of said register supplies said first erasing voltage.

7. A nonvolatile memory device according to claim 6, wherein a capacitance (Cs) between the source and the floating gate of said first memory cell and a capacitance (Cs') between the source and the floating gate of said second memory cell are different due to mismatch of a photo mask.

8. A nonvolatile memory device according to claim 4, wherein each of said first and second control signals and said select signal is outputted from said control means in response to a control signal from a central processing unit (CPU).

## Patentansprüche

1. Nicht-flüchtige Speichereinrichtung mit

einer Speicher-Array (MARY) mit einer Vielzahl von in einer Matrix angeordneten Paaren von Speicherzellen (Q), deren jedes eine erste Speicherzelle und eine zweite Speicherzelle aufweist, die mit ihren Source-Bereichen miteinander gekoppelt sind, wobei die ersten Speicherzellen eine Vielzahl von Matrixzeilen und die zweiten Speicherzellen eine weitere Vielzahl von Matrixzeilen bilden, und wobei jede der ersten und zweiten Speicherzellen einen Drain-Bereich, ein Gate und ein über dem Kanalbereich zwischen Source und Drain angeordnetes Steuer-Gate aufweist,
einer Vielzahl von in dem Speicher-Array angeordneten Source-Leitungen (S1, S2), deren jede mit dem Source-Bereich jede der paarweisen Speicherzellen gekoppelt ist,
einer Vielzahl von ersten Wortleitungen (WL1, WL3, WL5) und einer Vielzahl von zweiten Wortleitungen (WL2, WL4), die in dem Speicher-Array angeordnet sind, wobei jede der ersten Wortleitungen mit dem Steuer-Gate jeder ersten Speicherzelle (Q1, Q2) einer entsprechenden Zeile und jede der Vielzahl von zweiten Wortleitungen mit dem Steuer-Gate jeder zweiten Speicherzelle (Q3, Q4) einer weiteren entsprechenden Zeile gekoppelt ist, und
einer ersten Spannungsversorgung (SS) zur Zuführung einer ersten Löschspannung an die Source-Leitungen,

gekennzeichnet durch eine zweite Spannungsversorgung (DRV) zur selektiven Zuführung einer zweiten Löschspannung an entweder die Vielzahl von ersten Wortleitungen oder die Vielzahl von zweiten Wortleitungen.

2. Nicht-flüchtige Speichereinrichtung nach Anspruch 1, mit einer Steuereinrichtung (TG) zur Ausgabe eines ersten oder eines zweiten Steuersignals an die zweite Spannungsversorgung (DRV).

3. Nicht-flüchtige Speichereinrichtung nach Anspruch 2, wobei die Steuereinrichtung (TG) das erste Steuersignal ausgibt und die zweite Spannungsversorgung die zweite Löschspannung an die Vielzahl von ersten Wortleitungen (WL1, WL3, WL5) sowie eine Löschsperrspannung an die Vielzahl von zweiten Wortleitungen (WL2, WL4) anlegt, und wobei dann, wenn die Steuereinrichtung das zweite Steuersignal ausgibt, die zweite Spannungsversorgung die zweite Löschspannung an die Vielzahl von zweiten Wortleitungen und eine Löschsperrspannung an die Vielzahl von ersten Wortleitungen anlegt.

**4.** Nicht-flüchtige Speichereinrichtung nach Anspruch 3, wobei die erste Spannungsversorgung (SS) eine Vielzahl von Spannungsversorgungskreisen aufweist, und wobei einer der Spannungsversorgungskreisen, der entsprechend einem Wählsignal von der Steuereinrichtung (TG) ausgewählt wird, die erste Löschspannung zuführt.

**5.** Nicht-flüchtige Speichereinrichtung nach Anspruch 4, umfassend ein Register (CREG) mit einem Lösch-Bezeichnungsbit zum Bezeichnen eines Löschvorgangs, ein Schreib-Bezeichnungsbit zum Bezeichnen eines Schreibvorgangs, ein Verifikations-Bezeichnungsbit zum Bezeichnen eines Verifiziervorgangs und ein Löschblock-Bezeichnungsbit zum Bezeichnen mindestens einer der an die zu löschenden Speicherzellen anzukoppelnden Source-Leitungen.

**6.** Nicht-flüchtige Speichereinrichtung nach Anspruch 5, wobei die erste Spannungsversorgung (SS) eine Vielzahl von Spannungsversorgungskreisen aufweist und wobei einer diese Spannungsversorgungskreise, der entsprechend dem Löschblock-Bezeichnungsbits des Registers ausgewählt wird, die erste Löschspannung zuführt.

**7.** Nicht-flüchtige Speichereinrichtung nach Anspruch 6, wobei eine zwischen Source und potentialfreiem Gate der ersten Speicherzelle liegende Kapazität (Cs) und eine zwischen Source und potentialfreiem Gate der zweiten Speicherzelle liegende Kapazität (Cs') aufgrund Fehlpassung einer Photomaske unterschiedlich sind.

**8.** Nicht-flüchtige Speichereinrichtung nach Anspruch 7, wobei das erste und das zweite Steuersignal sowie das Wählsignal von der Steuereinrichtung entsprechend einem Steuersignal von einer Zentralverarbeitungseinheit (CPU) ausgegeben werden.

**Revendications**

**1.** Dispositif de mémoire non-volatile comportant :

une matrice mémoire (MARY) comportant une pluralité de paires de cellules de mémoire (Q), agencées en matrice, dont chaque paire a une première cellule de mémoire et une seconde cellule de mémoire ayant leurs sources reliées l'une à l'autre, les premières cellules de mémoire formant une pluralité de rangées de la matrice et les secondes cellules de mémoire formant une autre pluralité de rangées de la matrice, chacune desdites première et seconde cellules de mémoire ayant un drain, et une grille flottante et une grille de commande au-dessus d'une zone de canal formée entre ladite source et ledit drain,

une pluralité de lignes de source (S1, S2) agencées dans ladite matrice mémoire, chaque ligne parmi ladite pluralité de lignes de source étant reliée à ladite source de chacune desdites cellules de mémoire appariées,

une pluralité de premières lignes de mots (WL1, WL3, WL5) et une pluralité de secondes lignes de mots (WL2, WL4) agencées dans ladite matrice mémoire, chaque ligne de ladite pluralité de premières lignes de mots étant reliée à ladite grille de commande de chacune desdites premières cellules de mémoire (Q1, Q2) d'une rangée correspondante alors que chaque ligne de ladite pluralité de secondes lignes de mots est reliée à ladite grille de commande de chacune desdites secondes cellules de mémoire (Q3, Q4) d'une autre rangée correspondante, et

des premiers moyens d'alimentation en tension (SS) pour envoyer une première tension d'effacement vers lesdites lignes de source, caractérisé en ce que des seconds moyens d'alimentation en tension (DRV) envoient sélectivement une seconde tension d'effacement vers ladite pluralité de premières lignes de mots ou ladite pluralité de secondes lignes de mots.

**2.** Dispositif de mémoire non-volatile selon la revendication 1, comportant de plus des moyens de commande (TG) pour émettre un signal parmi des premiers et seconds signaux de commande vers lesdits seconds moyens d'alimentation en tension (DRV).

**3.** Dispositif de mémoire non-volatile selon la revendication 2, dans lequel lesdits moyens de commande (TG) émettent ledit premier signal de commande, et les seconds moyens d'alimentation en tension envoient ladite seconde tension d'effacement vers ladite pluralité de premières lignes de mots (WL1, WL3, WL5) et une tension empêchant l'effacement vers ladite seconde pluralité de secondes lignes de mots (WL2, WL4), et dans lequel lorsque lesdits moyens de commande émettent ledit second signal de commande, lesdits seconds moyens d'alimentation en tension envoient ladite seconde tension d'effacement vers ladite pluralité de secondes lignes de mots et une tension empêchant l'effacement vers ladite pluralité de premières lignes de mots.

**4.** Dispositif de mémoire non-volatile selon la revendication 3, dans lequel lesdits premiers moyens d'alimentation en tension (SS) comportent une pluralité de circuits d'alimentation en tension, dans lesquels un desdits circuits d'alimentation en tension sélectionné conformément à un signal de sélection provenant desdits moyens de commande (TG), délivre ladite première tension d'effacement.

5.  Dispositif de mémoire non-volatile selon la revendication 4, comportant de plus un registre (CREG) ayant : un bit de désignation d'effacement pour désigner une opération d'effacement ; un bit de désignation d'écriture pour désigner une opération d'écriture ; un bit de désignation de vérification pour désigner une opération de vérification ; un bit de désignation d'effacement de bloc pour désigner au moins une desdites lignes de source à coupler aux cellules de mémoire à effacer.

6.  Dispositif de mémoire non-volatile selon la revendication 5, dans lequel lesdits premiers moyens d'alimentation en tension (SS) comportent une pluralité de circuits d'alimentation en tension, un desdits circuits d'alimentation en tension sélectionné conformément au bit de désignation d'effacement de bloc dudit registre, délivrant ladite première tension d'effacement.

7.  Dispositif de mémoire non-volatile selon la revendication 6, dans lequel une capacité (Cs) située entre la source et la grille flottante de ladite première cellule de mémoire et une capacité (Cs') située entre la source et la grille flottante de ladite seconde cellule de mémoire sont différentes du fait d'un défaut d'alignement d'un masque photosensible.

8.  Dispositif de mémoire non-volatile selon la revendication 4, dans lequel chaque signal parmi lesdits premiers et seconds signaux de commande et ledit signal de sélection est émis par lesdits moyens de commande en réponse à un signal de commande provenant d'une unité centrale de traitement (CPU).

# FIG. 1

# FIG. 2

WRITE

ERASE

READ OUT

# FIG. 3(A)

# FIG. 3(B)

MEMORY CELL A'        MEMORY CELL A

FIG. 4

DEPENDENCY OF ERASURE CHARACTERISTICS UPON WL-SL SIZE

EP 0 562 737 B1

# FIG. 5

# FIG. 6

WRITE

| MEMORY ELEMENT | SELECT/UNSELECT | GATE | DRAIN | SOURCE |
|---|---|---|---|---|
| Q1 | SELECT | 12V | 6V | 0V |
| Q2 | UNSELECT | 12V | 0V | 0V |
| Q3 | UNSELECT | 0V | 6V | 0V |
| Q4 | UNSELECT | 0V | 0V | 0V |

ERASE (EVEN ROW)

| MEMORY ELEMENT | SELECT/UNSELECT | GATE | DRAIN | SOURCE |
|---|---|---|---|---|
| Q1, Q2 | SELECT | 0V | OPEN | 12V |
| Q3, Q4 | UNSELECT | 6V | OPEN | 12V |

ERASE (ODD ROW)

| MEMORY ELEMENT | SELECT/UNSELECT | GATE | DRAIN | SOURCE |
|---|---|---|---|---|
| Q1, Q2 | UNSELECT | 6V | OPEN | 12V |
| Q3, Q4 | SELECT | 0V | OPEN | 12V |

(POSITIVE VOLTAGE USED)

# *FIG. 7*

WRITE

| MEMORY ELEMENT | SELECT/UNSELECT | GATE | DRAIN | SOURCE |
|---|---|---|---|---|
| Q1 | SELECT | 12V | 6V | 0V |
| Q2 | UNSELECT | 12V | 0V | 0V |
| Q3 | UNSELECT | 0V | 6V | 0V |
| Q4 | UNSELECT | 0V | 0V | 0V |

ERASE (EVEN ROW)

| MEMORY ELEMENT | SELECT/UNSELECT | GATE | DRAIN | SOURCE |
|---|---|---|---|---|
| Q1, Q2 | SELECT | -10V | OPEN | 5V |
| Q3, Q4 | UNSELECT | 0V | OPEN | 5V |

ERASE (ODD ROW)

| MEMORY ELEMENT | SELECT/UNSELECT | GATE | DRAIN | SOURCE |
|---|---|---|---|---|
| Q1, Q2 | UNSELECT | 0V | OPEN | 5V |
| Q3, Q4 | SELECT | -10V | OPEN | 5V |

(POSITIVE/NEGATIVE VOLTAGE USED)

# FIG. 8

```
                    ( START )
                        │
                        ▼
                   ┌──────────┐
                   │ PREWRITE │
                   └──────────┘
                        │
                        ▼
              ┌────────────────────┐
              │ SET EVEN ROW ADDRESS │
              └────────────────────┘
                        │
                        ▼
              ┌────────────────────┐
              │   ERASE EVEN ROW   │◄─────────┐
              └────────────────────┘          │
                        │                      │
                        ▼           NO         │
                  < VERIFIED ? >───────────────┘
                        │
                        │ YES
                        ▼
    ┌──────────────────────┐      NO
    │ ADDRESS NEXT EVEN ROW │◄─── < FINAL ADDRESS OF EVEN ROW ? >
    └──────────────────────┘
                                       │ YES
                                       ▼
                            ┌────────────────────┐
                            │ SET ODD ROW ADDRESS │
                            └────────────────────┘
                                       │
                                       ▼
                            ┌────────────────────┐
                            │   ERASE ODD ROW    │◄────────┐
                            └────────────────────┘         │
                                       │          NO       │
                                       ▼                   │
                                 < VERIFIED ? >────────────┘
                                       │
                                       │ YES
                                       ▼
    ┌──────────────────────┐     NO
    │ ADDRESS NEXT ODD ROW │◄─── < FINAL ADDRESS OF ODD ROW ? >
    └──────────────────────┘
                                       │ YES
                                       ▼
                                   ( END )
```

# FIG. 9

# FIG. 10

# FIG. 11(A)

# FIG. 11(B)

# FIG. 12

# FIG. 13

# FIG. 14

```
                                    ( START )
                                        │
                                        ▼
                                  ┌───────────┐
                                  │  PREWRITE │
                                  └───────────┘
                                        │
                                        ▼
                      ┌─────────────────────────────────┐
                      │ SET EVEN ROW ADDRESS OF 1ST BLOCK│
                      └─────────────────────────────────┘
                                        │
                                        ▼
                      ┌─────────────────────────────────┐
                      │   ERASE EVEN ROW OF 1ST BLOCK    │◄──┐
                      └─────────────────────────────────┘   │
                                        │                    │ NO
                                        ▼                    │
                                  ◇ VERIFIED ? ◇─────────────┘
                                        │ YES
                                        ▼
   ┌──────────────────┐          ◇ FINAL ◇
   │ ADDRESS NEXT EVEN │◄── NO ── ◇ ADDRESS OF EVEN ROW OF 1ST BLOCK ? ◇
   │ ROW OF 1ST BLOCK  │                │
   └──────────────────┘                │ YES
                                        ▼
                      ┌─────────────────────────────────┐
                      │ SET ODD ROW ADDRESS OF 1ST BLOCK │
                      └─────────────────────────────────┘
                                        │
                                        ▼
                      ┌─────────────────────────────────┐
                      │    ERASE ODD ROW OF 1ST BLOCK    │◄──┐
                      └─────────────────────────────────┘   │
                                        │                    │ NO
                                        ▼                    │
                                  ◇ VERIFIED ? ◇─────────────┘
                                        │ YES
                                        ▼
   ┌──────────────────┐          ◇ FINAL ◇
   │ ADDRESS NEXT ODD  │◄── NO ── ◇ ADDRESS OF ODD ROW OF 1ST BLOCK ? ◇
   │ ROW OF 1ST BLOCK  │                │
   └──────────────────┘                │ YES
                                        ▼
                      ┌─────────────────────────────────┐
                      │ SET EVEN ROW ADDRESS OF 2ND BLOCK│
                      └─────────────────────────────────┘
                                        ┊
                                        ▼
                                    ( END )
```

# FIG. 15

## FIG. 16

# FIG. 17

H'0000

RELOAD CONTROL PROGRAM
WRITTEN ALREADY BY GENERAL
PURPOSE PROM WRITER

- - - - - - - - - - - - - - - - - - - - - - - - - -

FLASH MEMORY

PROGRAM
ERASE

VERIFY

H'EE7F
H'EE80

H'F67F
H'F680

RAM

EXECUTE RELOAD CONTROL
PROGRAM TRANSFERRED

TRANSFER

H'EE7F
H'EE80

INTERNAL REGISTER

H'FFFF

# FIG. 18

CONTROL REGISTER

PROGRAM/ERASE CONTROL REGISTER

| Vpp | | EVO | EVE | PV | EO | EE | P |
|-----|---|-----|-----|----|----|----|---|

~PEREG

ERASE BLOCK DESIGNATE REGISTER    ~MBREG1

| 7 | 6 | 5 | 4 | 3 | 2 | 1 | 0 |
|---|---|---|---|---|---|---|---|

} CREG

ERASE BLOCK DESIGNATE REGISTER    MBREG2

| 7 | 6 | 5 | 4 | 3 | 2 | 1 | 0 |
|---|---|---|---|---|---|---|---|

Vpp:Vpp APPLY FLAG        E:ERASE
                          P:PROGRAM
EV:ERASE VERIFY
PV:PROGRAM VERIFY

MBREG1:BLOCK DESIGNATE REGISTER
MBREG2:BLOCK DESIGNATE REGISTER